# EUROPEAN PATENT SPECIFICATION

(11) **EP 3 235 395 B1**
(45) Date of publication and mention of the grant of the patent: **03.10.2018**
(21) Application number: 17153267.4
(22) Date of filing: 26.01.2017
(51) Int. Cl.: A43B 3/00, A43B 5/00, H02J 7/00, H02J 7/32, H02J 7/34, H04W 4/80, A43B 13/14, H01L 41/113, H02N 2/18

(54) **ENERGY HARVESTING SOLE**
ENERGIE GEWINNENDE SOHLE
SEMELLE DE COLLECTE D'ÉNERGIE

(30) Priority: 27.01.2016 DE 102016201152
(43) Date of publication of application: 25.10.2017
(73) Proprietor: adidas AG, 91074 Herzogenaurach (DE)
(72) Inventor: TORVINEN, Vesa-Pekka, 91074 Herzogenaurach (DE); WELKER, Michael, 91074 Herzogenaurach (DE); DÜMLER, Burkhard, 91074 Herzogenaurach (DE); NORRIDGE, Marc Simon Anthony, 91074 Herzogenaurach (DE)
(74) Representative: Wegner, Hans

(56) References cited:
- EP-A1- 1 612 059
- US-A1- 2010 090 477
- US-A1- 2014 088 917
- US-A1- 2014 260 677
- US-A1- 2015 068 069

## Description

### I. Technical field

The present invention relates to a system for a shoe sole with at least one module comprising at least one piezoelectric element.

### II. Prior art

To many people, sport is an integral part of their life. For instance, people go running to improve their fitness and to live a healthy lifestyle. With the advent of smartphones, it has also become common to monitor one's training performance during or after the training for improving the training, and even for sharing the results with friends, for instance via social networks.

To this end, various approaches are known to obtain data, such as number of steps, distance travelled, cadence, pace, speed, and so on. For instance, smartphones provide apps which may be used for monitoring activities via integrated sensors such as GPS sensors and / or motion sensors in the smartphone.

Other approaches involve sensors which are placed somewhere on the person or the sports apparel, e.g., the shoes. Prior approaches involve sensors placed somewhere in the sole of a shoe to measure at least some of the above mentioned parameters. During or after the workout, the measured parameters may then be transferred to a monitoring device such as a smartphone.

Most of the above mentioned sensors include a battery to be able to measure the desired data. As a consequence, from time to time the battery becomes empty and needs to be replaced with new a new battery. For some sensor models, it may even be necessary to replace the complete device. It is apparent that these solutions pose a significant burden on the environment. Consequently, further approaches have been considered by the industry.

One example of other sensors involves piezoelectric elements for generating energy during an exercise which may be stored or used for operating the respective sensors. For example, the US patent application publication US 2013/0028368 relates to a pedometer for a shoe. An electromotive unit comprising a piezoelectric element produces an electric current in response to a pressure applied thereto when a user lands with his foot on the ground. The electric current is provided to an external pedometer unit to perform counting of steps.

Another solution is disclosed by the article "Insole Pedometer With Piezoelectric Energy Harvester and 2V Organic Circuits" by Ishida et al., published in IEEE Journal of solid-state circuits, Vol. 48, No. 1, January 2013, describes a shoe insole pedometer which consists of a piezoelectric energy harvester and includes a pseudo-CMOS 14 bit step counter that records the number of steps using the harvested power. Each time the insole is pressed by the foot during walking the piezoelectric energy harvester, which is a rolled polyvinylidene difluoride (PVDF) sheet, generates a pulse. Other PVDF rolls which are also included in the shoe sole may be used as power supply for the organic circuits.

The US patent application publication US 2014/0088917 also discloses a step counter with energy scavenging functionality. To this end, a step-counter device detects and counts user steps. The device includes a transducer, which could be of the piezoelectric type, which is configured to generate an electrical transduction signal in response to user stepping. An energy-scavenging system is coupled to the transducer to generate a power supply voltage in response to the electrical transduction signal. A processing unit is powered by the power supply voltage. The processing unit is further configured to sense the electrical transduction signal and determine whether a user step has occurred and in response to that determination increment a step counter.

Further prior art is disclosed in DE 103 49 357 A1, US 2006 / 0 028 333 A1, and DE 60 2004 009 229 T2.

US 2014/260677 A1 discloses a system for a shoe sole.

While the above approaches somewhat contribute towards a reduction of adverse effects on the environment, from a practical point of view they still have various disadvantages. For instance, such sensors are complex to manufacture, are relatively big and may not be practical to use in various conceivable situations. For example, it may not be possible to use the sensors or the obtained data when not using the shoe, e.g., during a short break or after the workout.

It is therefore an objective underlying the present invention to provide improved piezoelectric sensor systems to be used for monitoring various parameters, which are easy to produce, conveniently small to be placed internally of the shoe sole and which provide a superior usability to the athlete.

### III. Summary of the invention

The invention relates to a system for a shoe as specified in claim 1, to a shoe sole as specified in claim 15 and to a shoe as specified in claim 16. Preferred embodiments are specified in the dependent claims.

This objective is at least partly solved by a system for a shoe sole with at least one module, the module comprising at least one piezoelectric element adapted to produce an electrical signal upon mechanical deformation of the at least one piezo element (herein also referred to as piezoelectric element). The electrical signal is adapted to be used as signal for deriving at least one motion parameter of the shoe sole. The system further comprises at least a first energy storage and a second energy storage, the at least first energy storage and second energy storage being adapted to store electrical energy obtained from the electrical signal, and the second energy storage is loaded only after the first energy storage reaches a first energy threshold.

The use of modules including piezoelectric elements offers various advantages such as avoiding the necessity of external power sources. Nevertheless, creating its own energy from scratch also means that in order to being able to use the modules and the system, a certain amount of initial motion of the wearer of the shoe is necessary, to create a minimum amount of energy that is required for operating the system and the modules. The reason is that only if sufficient energy is available, electric signals may be processed and parameters may be determined (and, e.g., locally stored) in the system. By providing a first energy storage which may be used to quickly operate the system, or at least the most important parts thereof, a proper function of the system may be ensured. The storage size of the first energy storage (e.g., capacitance) may be kept as small as possible so as to get the basic functionality (e.g., one or more control elements such as logic IC and / or regulator IC) to run. Having a small capacitance, the voltage in the capacitor will rise faster (U=Q/C), where C is capacitance, Q is charge and U is voltage. However, the capacitance cannot be too small, because when the basic control elements start to work, they will take extra start up power / charge which causes a voltage drop in the capacitor. The step counting may then start in the control logic (e.g., in the logic IC). On the other hand, by additionally providing a second energy storage which is charged only when the first energy storage reaches a first energy threshold (and remains above that threshold), further functionality may be used. When the control elements (e.g., regulator IC and logic IC) are running, they will take certain amount of power/charge. The extra power/charge is loaded to the second energy storage (e.g., a capacitor). When the energy stored in the second energy storage (e.g., the capacitor voltage reaches certain level), the control element (e.g., logic IC) may allow to turn ON additional control elements such as a microcontroller or a controller for remote transmission (e.g., a Bluetooth Low Energy (BTLE), Bluetooth, Bluetooth Smart, IrDA, Near Field Communication (NFC), cellular network, ZigBee, Wifi, or other controller using suitable standards). These elements will draw a certain amount of power/charge and it is feed from first capacitor via another control element (e.g., a regulator IC). In one example, the second capacitor supports the first capacitor via a feedback diode, which may be a Schottky type diode. The term sole as used in this document may refer to an insole or a midsole.

The system may also comprise a third energy storage being adapted to store electrical energy obtained from the electrical signal.

The capacity of the third energy storage may be larger than that of the first and the second energy storages so that when the athlete has to pause for a moment or even after the activity, data may be transferred from the system to an external and remote device, such as a smartphone, smartwatch, tablet computer, personal computer or another device. This is advantageous because it can be ensured that the time needed for getting the module ready is reduced by using the first energy storage without taking the risk that meanwhile the energy has been used for other, less necessary, aspects such as data transmission to a remote device, operation of LEDs and so on. It is therefore better to have separately controllable storage devices. The type of third capacitor may be super cap, thin film lithium battery or similar. The leakage current in the third energy storage should be as small as possible to keep the charge several hours/days. For example, this may be achieved by suitable selection of the storage device, e.g., the capacitor. For instance, some capacitors may have lower leakage than other capacitors. In one example, the third energy storage may also be charged in the factory during manufacturing process. However, alternatively or in addition it may also be charged during use. In one example, the third energy storage is loaded only after the second energy storage has reached a threshold voltage.

The system may be provided so that the first energy storage is adapted to supply energy for processing the derived at least one motion parameter, wherein the second energy storage is adapted to supply energy for a control element and / or radio frequency functionality, and wherein the third energy storage is adapted to supply energy for transmitting the derived motion parameters. In one example, if three capacitors are used as energy storages, the capacities of the respective capacitors may be as follows: First capacitor: 40-100µF; Second capacitor: 100-200µF; Third capacitor: 2-15mF.

The third energy storage may be adapted to supply energy for transmitting motion parameters (e.g., to a remote device), when the shoe sole is not moving and the piezoelectric elements are not deformed. As an example, the motion parameters determined can be transmitted to a remote device such as a smartphone, smartwatch, tablet computer, personal computer or another suitable device. It may be advantageous and convenient to monitor the obtained data at a remote device (e.g., during a short break or after the workout). Known solutions do not offer such convenient access to the data because the devices only generate energy that is available while using the device. There is no energy storage for providing energy during breaks or, at least for some time, after the workout that is sufficient for transferring the data from the module to the remote device. However, this concept may also be applied to the second energy storage.

The system may also comprise a control element, wherein the control element is adapted for controlling and / or monitoring the energy levels of the energy storages. The term control element used herein may refer to a microcontroller, a logic element, a programmable logic element, or other active IC component. In one example, the main control element in this system has a programmable logic. Control elements have advantageous properties for controlling the system and in particular the modules. For instance, the control element can control the energy flow in the system and in particular from the piezoelectric sensor to the various energy storages. It may also be configured to operate the RF device, e.g., the antenna. Data transmission via the RF device such as the antenna may occur periodically or aperiodically. For instance, in aperiodic transmission scenarios, data may only be transmitted when a buffer is full or upon specific user interaction (e.g., by pressing a button). The specific user interaction may also involve the reception of a request signal from the remote device (e.g., during or after the workout). This may be advantageous if it is not necessary to constantly monitor the measured parameters. Different control elements may be used for different purposes as will be explained in more detail below.

Further, the system may comprise at least one power valve for controlling the energy flow to the first and the second energy storages or, if present, between the first and the third energy storages and / or between the second and the third energy storages. Depending on the number of energy storages, the number of power valves may vary. For instance, there may be one dedicated power valve for each energy storage. The power valve may advantageously control when to use the first energy storage and when to use the second energy storage, or, more generically, when to use any of the energy storages. In this way, an improved operation and use of available resources can be obtained.

The energy storages can be capacitors, supercapacitors, thin film lithium batteries, or other types of suitable energy storages Of course, various combinations of any of these types may be used. For instance, the first energy storage may be a capacitor, and the second energy storage may be a thin film lithium battery. In this way, different properties and advantages of the respective type of energy storage may be optimally used. As an example, an energy storage of a first type may quickly charge but cannot hold the stored energy for a longer time period. Another energy storage may need longer to charge but be able to store the energy for a longer time period.

The system may be operated by using only energy obtained from the electric signal of the piezoelectric elements. In this way, the system is self-sustained and completely independent from external energy sources. This allows to provide a hermetically sealed construction of the system because it is not required to provide access to any of the components or to maintain an external interface for plugs for charging or other purposes. By sealing the system, it is water proof and the mechanical construction becomes less complex because no openings (like battery covers) are needed. This way of construction also allows for a simpler construction of the sole. It is noted that every embodiment as described herein may be provided as a hermetically sealed construction.

The piezoelectric element may comprise at least two piezoelectric plates. By using more than only one plate of a piezoelectric element, it is possible to create more energy while exerting force. Since all of the plates of the piezoelectric elements may be deformed and thus create an electric signal, using two or more of them can be advantageous if more energy is needed than can be created by using a single-plated piezoelectric element.

Further, the system could comprise an antenna for transmitting data obtained from the electrical signal. The antenna could be integrated into the module, but it could also be provided external to the module. In one example, the antenna may be flexible and formed within the insole of the shoe. By having an external antenna, a better transmission of data may be realized.

The module may further comprise a rectifier for processing the electrical signal to be stored in one of the energy storages. The electric current from the piezoelectric elements is alternating current (AC), and the rectifier converts the AC current into a direct current (DC) to be provided to the energy storages. Consequently, the rectifier allows to use the electric current and thus electrical energy resulting from deformation of the piezoelectric elements in both directions.

The system may comprise a radio frequency device, wherein the radio frequency device is adapted to transmit and / or receive data to and / or from an external and remote device. In one example, the data may be transmitted in accordance with the Bluetooth Low Energy (BTLE) standard. Other possible transmission standards may involve ZigBee, Near Field Communication (NFC), Bluetooth, Bluetooth Smart, IrDA, WiFi, cellular network standards or other suitable standards.

The system may comprise additional sensors to measure specific movements of the shoe, e.g. accelerometer(s) to get distance, speed, pace, movement time, gyroscope(s) to get orientation data, magnetometer(s) to get magnetic data, temperature sensor(s) to measure temperature, pressure sensor(s) to get pressure at specific points within the sole, GPS (or Galileo, GLONASS) to get position and performance data (speed, pace, distance, time). Different combinations of sensors may be used. A suitable control element may be provided which controls the operation of the respective sensors and may allow for selectively switching on and off of some or all of the sensors. For example, it may not be necessary to frequently measure the position or the temperature. Thus, in order to save energy, the respective control element may be adapted to control the operation of the corresponding sensors.

The system may comprise a memory which saves all measured and detected data. Memories to be used comprise RAM, ROM, flash memory and other types of memories generally known to the skilled person.

The system may comprise a battery which is be used together with the piezo element and may also be used as fall back position if the energy which is created would not be efficient enough to detect the performance data or to transmit these data.

The at least one motion parameter may relate to one or more of: step count, cadence, acceleration, speed, pace, time, distance, or event detection (distinguishing between walking, jogging, running, standing still). The electrical signal may further be used for determining a duration of use of the shoe. This can be achieved with a built-in timer which gets activated every time when a motion is detection. In another example, the activation time of at least one piezo element (or accelerometer / gyroscope / magnetometer) can be accumulated to determine the duration of used of the shoe. This allows an easy determination of activity relevant parameters by using the self-contained system exclusively based on the harvested energy.

The module may comprise at least one support ring for protecting the module. The support ring may limit movement of the cover to protect the components. In particular, the support ring may prevent overbending of the plates of the piezoelectric element.

The module may comprise at least one press bar for actuating the piezoelectric element. Providing such a press bar (or short "bar") can help bending the plates of the piezoelectric elements while using the shoe. Of course, the bar can have different shapes such as a longitudinal shape, a cross shape, a circle shape and other types of shapes. It is also conceivable to have more than one bar, e.g., one on the top of the module and one on the bottom of the module to improve the bending. The shapes of the bars on top and on the bottom of the module may be different. The bar material can be made of different plastics, rubber, or other suitable materials. It may also be possible to have no bar at all and to use the piezo material as the activator.

The module may comprise at least one brass cover for conveying the electrical signal. Brass covers can serve different functions. On the one hand, they may provide electrical connection between the piezoelectric element and other components of the module. These other components may be electronic components or an antenna. In this sense, the at least one brass cover may not only be used as protection, but also as conductive element. It is also conceivable to use a plastic cover or a rubber cover. If the cover material is non-conductive, an electrical connection may be provided via directly connecting a flexible conductive material (e.g., a wire or conductive tape) between the various components such as control elements, sensors and piezo elements. Moreover, it is conceivable to not use a cover. When not using a cover, a conductive adhesive may be used. For example, conductive adhesives may be provided by 3M company. Conductive tapes can be used to avoid conventional grounding means (screws or fasteners). Moreover, they provide increased flexibility.

The thickness of the at least one module may be less than 5 mm, preferably less than 3 mm. By providing a module having a thickness of less than 3mm, it can easily be integrated into typical insoles without requirement of substantial reconstruction of the other parts of the shoe. It is also advantageous to have a thin module so as not to reduce the comfort of the shoe for the wearer.

The module may be integrated into a cavity or recess of an insole, a midsole or an outsole of a shoe. Depending on one or more of the needs of the athlete, the properties of the shoe and the number of modules, one or more of the modules can be integrated within different parts of the shoe or the shoe sole. For example, a first module can be provided in the insole, while a second module can be provided in the outsole or in the midsole.

The modules may be placed within the sole (e.g., the insole or the midsole) of the shoe so that they are exposed to maximum forces while treading onto the ground. The modules may be arranged in the heel area and / or the forefoot area of the sole. During use of the shoe and the shoe sole, respectively, there can be regions which are subject to more pressure than other parts of the shoe or the shoe sole. For example, the pressure in the heel region may be substantially higher than in the midfoot section. Also, the pressure in the forefoot region may be higher than in the midfoot region. Which region is subject to the highest pressure may also depend on the specific activity, e.g., it can make a difference whether the wearer is running or playing basketball. Therefore, by placing the modules in the shoe sole and taking into account these aspects, improved energy efficiency may be obtained.

The modules may be placed within the midsole of the shoe so that they are exposed to maximum forces while treading onto the ground. The modules may be arranged in the heel area and / or the forefoot area of the midsole. During use of the shoe and the shoe midsole, respectively, there can be regions which are subject to more pressure than other parts of the shoe or the shoe midsole. For example, the pressure in the heel region may be substantially higher than in the midfoot section. Also, the pressure in the forefoot region may be higher than in the midfoot region. Which region is subject to the highest pressure may also depend on the specific activity, e.g., it can make a difference whether the wearer is running or playing basketball. Therefore, by placing the modules in the shoe midsole and taking into account these aspects, improved energy efficiency may be obtained.

### IV. Brief description of the figures

Possible embodiments of the present invention are further described in the following detailed description with reference to the following figures:
- **Fig. 1:**: schematic drawing of an insole including energy harvesting buttons and electronics in accordance with one example;
- **Fig. 2:**: upper view of an insole in accordance with one example;
- **Fig. 3:**: schematic lateral drawing of an energy harvesting button in accordance with one example;
- **Fig. 4:**: schematic drawing of an energy harvesting button in accordance with one example;
- **Fig. 5a-5g:**: schematic drawing of an energy harvesting button and the operation thereof in accordance with one example;
- **Fig. 6:**: lateral view of an energy harvesting button in accordance with one example;
- **Fig. 7:**: conceptual diagram of an energy harvesting button in accordance with one example;
- **Fig. 8:**: schematic drawing of an insole and energy harvesting button in accordance with one example;
- **Fig. 9:**: conceptual diagram of an energy harvesting button including various sensors in accordance with one example;
- **Fig. 10:**: view of an insole comprising an energy harvesting button and several pressure sensors in accordance with one example;
- **Fig. 11:**: view of an insole comprising an energy harvesting button and several pressure sensors, and additional sensors in accordance with one example; and
- **Fig. 12:**: schematic drawing of an energy harvesting button in accordance with one example;

### V. Detailed description of the figures

In the following, exemplary embodiments of the present invention will be described in further detail with respect to the figures. While some of the following examples are described for an "energy harvesting button," it is to be noted that this is only an exemplary type of a module. The invention may also be implemented in other ways, e.g., wherein the module is provided as another type of "energy harvesting" module. Thus, it is to be understood that any reference to an "energy harvesting button" that is made herein is not to be understood to be limited to the specific shape of a button.

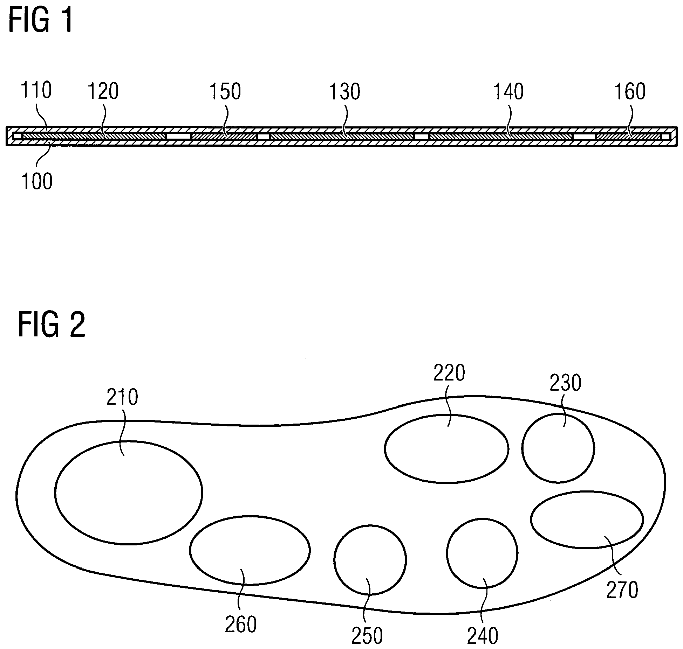

Fig. 1 shows a lateral view of an exemplary insole for a shoe, the insole comprising a lower part 100 and an upper part 110. In between the lower part 100 and the upper part 110 there are three energy harvesting buttons comprising piezoelectric elements 120, 130, 140 arranged therein. Moreover, in this example, the three piezoelectric elements 120, 130, 140 are controlled by two electronic components 150, 160. For example, electronic component 150 may control piezoelectric element 120, while electronic component 160 may control piezoelectric elements 130, 140. Exemplary energy harvesting buttons comprising piezoelectric elements and electronic components will be described in further detail below.

Fig. 2 is an upper view of an insole for a shoe, wherein the insole comprises several energy harvesting buttons comprising piezoelectric elements and electronic components. In this example, one energy harvesting button comprising a piezoelectric element 210 is placed in the heel area of the sole, while three energy harvesting buttons comprising piezoelectric elements 220, 230 and 240 are placed in the forefoot area of the sole. One energy harvesting button comprising piezoelectric element 250 is placed in the lateral midfoot region of the sole. Moreover, the illustrated energy harvesting buttons comprising piezoelectric elements 210, 220, 230, 240, 250 are controlled by two electronic components 260, 270. Having less electronic components than energy harvesting buttons comprising piezoelectric elements is advantageous because it reduces the need of electric power for operation and also the necessary space in the sole. Moreover, it is possible to use only a part of the energy harvesting buttons comprising piezoelectric sensors and thus the electric components at a time. In one example, only the energy harvesting button comprising piezoelectric sensor 210 in the heel and the electronic component 260 may be used. In another example, the electronic components 260 and 270 may be interconnected. In one example, only one of the electronic components comprises data transmission means such as an antenna. This will be explained in further detail below.

The energy harvesting buttons comprising piezoelectric sensors and the electronic components may be arranged in the sole so that the maximum force is exerted onto the piezoelectric elements comprised in the energy harvesting buttons while the force exerted on the electronic components is kept as low as possible. In this way, it is possible to protect the electronic devices while ensuring an optimal energy gain from the bending of the piezoelectric elements.

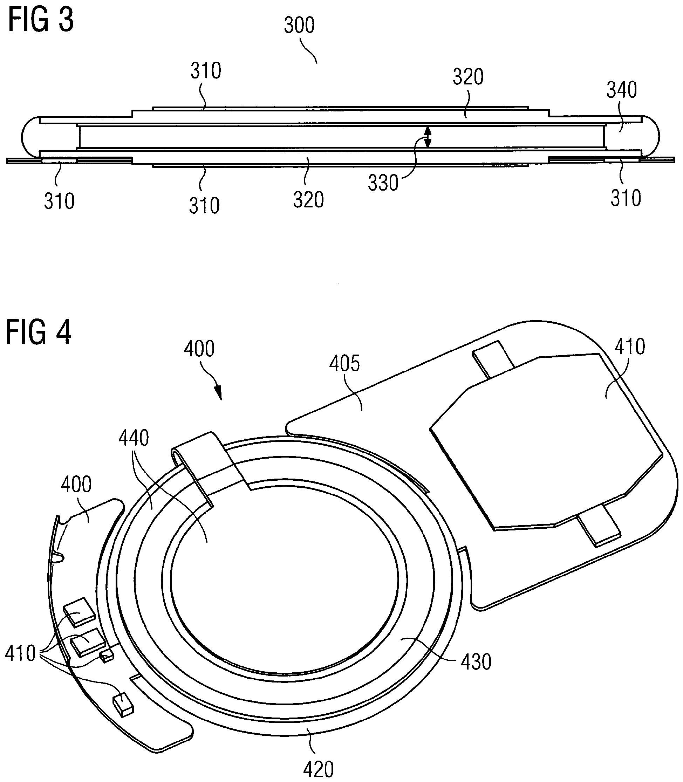

Fig. 3 is a lateral view of an exemplary energy harvesting button 300 in accordance with various examples of the present invention. Herein, the energy harvesting button 300 comprises a support ring 340, and multiple flexible printed circuit boards (PCB) 310. In between, the piezoelectric elements 320 can be deformed when a force is exerted on them. The piezoelectric elements may have a controlled travel distance 330 in the energy harvesting button 300, which is defined by the support ring 340.

Fig. 4 shows another exemplary energy harvesting button 400 in accordance with various examples of the present invention (as discussed above, the term "button" is not to be understood in a limiting manner; rather, the button may have any suitable shape). The energy harvesting button 400 comprises a housing 405 which includes areas for placing electronics 410, energy storages (e.g., capacitor, super capacitor, thin film Lithium battery or other suitable types of energy storages), and the antenna. The energy harvesting button 400 may also include a disc element 420 (e.g., circular shape or elliptical shape) which prevents the piezoelectric element 430 from overbending. The area where the piezoelectric elements 430 are placed may be raised with respect to the disc element 420 to allow for bending of the piezoelectric element 430. The piezoelectric element 430 may be connected with the control elements and the other elements of the energy harvesting button 400 (such as energy storage(s), sensor(s) or antenna(s)) via a flexible circuit or a conductive adhesive 440. In one example, the energy harvesting button 400 may be opened and closed via a lid so as to provide a hermetically sealed component.

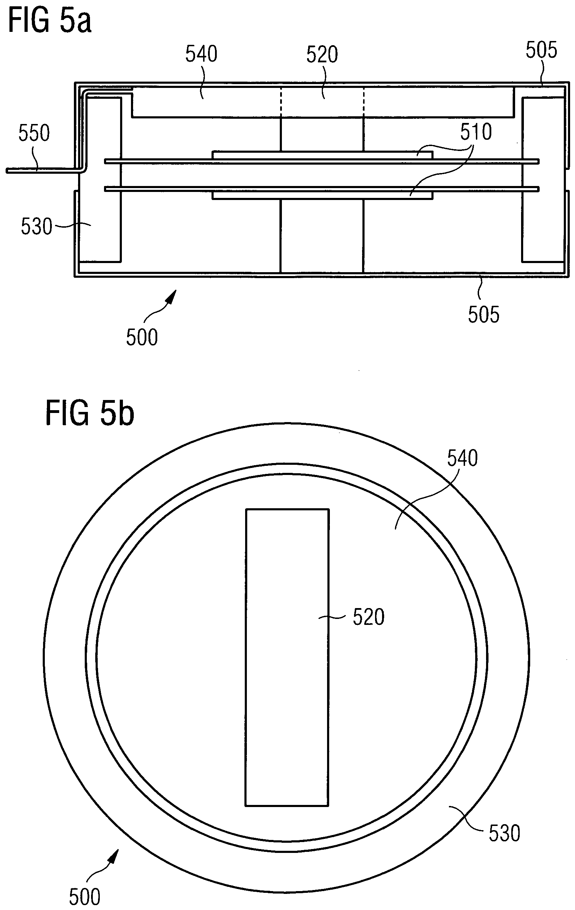

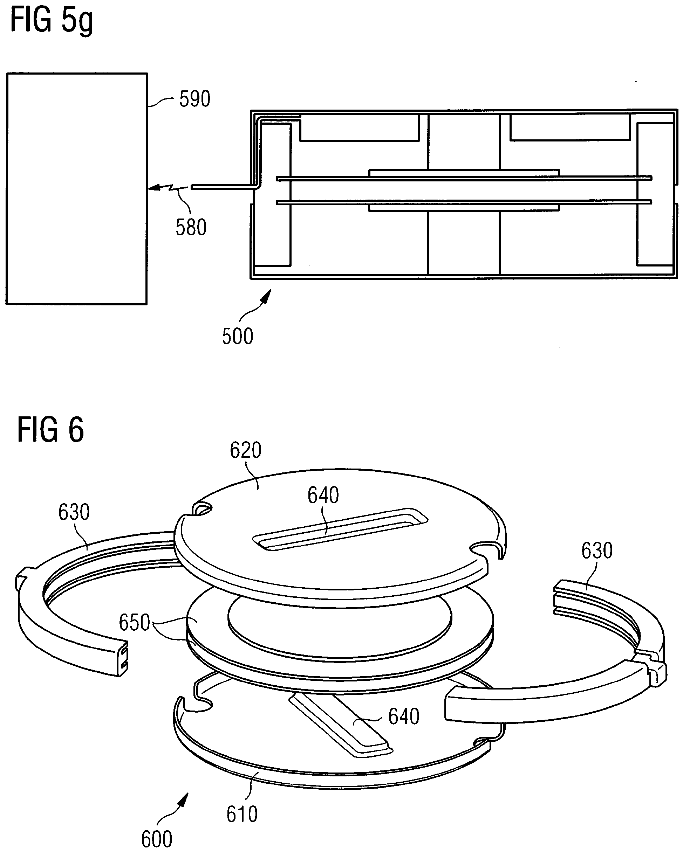

Fig. 5a shows a cross-sectional view of another exemplary energy harvesting button 500 in accordance with an example of the present invention. In this example, the energy harvesting button 500 comprises two covers 505, one upper cover and one lower cover. The covers 505 may be used as protection (e.g., to provide a strong or a waterproof construction). In case the covers are made from a conductive material (e.g., brass, or a flexible printed circuit (FPC) with a copper layer and conductive adhesive, covers 505 may also serve as conductive elements to convey electricity and / or signals to the electronic component 540, which may also be comprised in the energy harvesting button 500. The illustrated energy harvesting button 500 comprises two piezoelectric plates 510 in the center of the energy harvesting button 500, both placed on ceramics, wherein the ceramics extend to the sides and are connected to a support ring 530. The support ring 530 limits the movement of the covers 505 and in this way prevents overbending of the piezoelectric plates. In this example, the electronic component 540 of the energy harvesting button 500 is fully provided in the energy harvesting button 500, and only a connection to an external energy storage (e.g., battery) 550 is brought outside. Alternatively or additionally, it is conceivable that the antenna is brought outside of the energy harvesting button 500 which may provide for better data transmission properties. However, depending on the specific construction, the antenna could also be fully integrated within the energy harvesting button 500. Moreover, the upper and lower parts of the energy harvesting button 500 (the covers) may also comprise one or more bars 520. These bars 520 may extend from the cover to the piezoelectric plates 410 and thus move and press the piezoelectric plates 510. In the illustrated example, there is one bar from the lower side and one bar from the upper side extending to the respective and upper piezoelectric plate. However, it is also conceivable to use other constructions. For instance, the shape of the bars could be different, or only a single bar is used instead of two. Also another number of bars can be used depending on the specific construction thereof.

Fig. 5b shows a top view of the energy harvesting button 500, wherein the upper cover has been removed so that the support ring 530 can be seen which provides protection for the piezoelectric elements and the electronic components 540. The upper bar 520 can also be seen, which allows to bend the piezoelectric element (not shown in this figure).

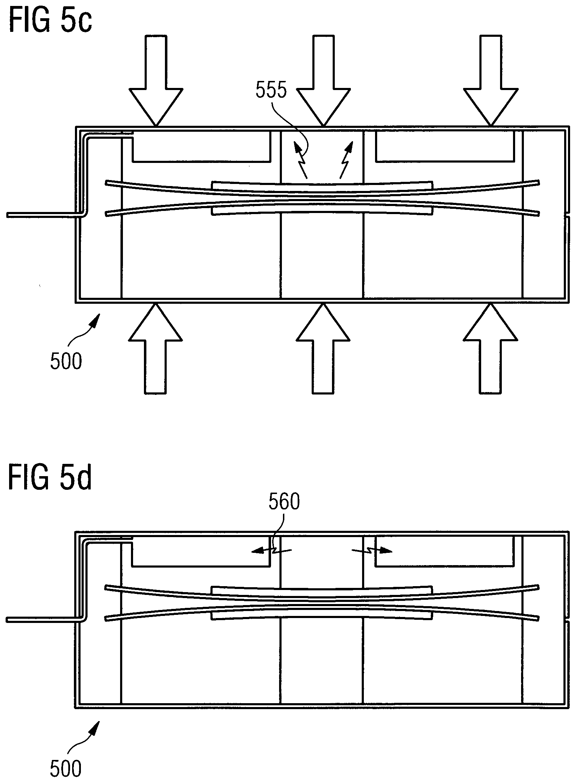

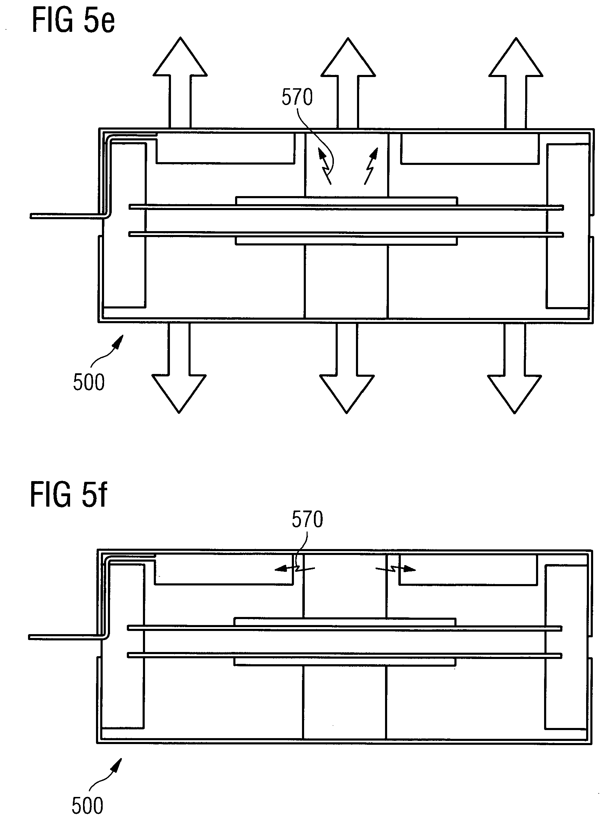

The following figures 5c to 5g (all of which are sectional views like Fig. 5a) show an exemplary operation cycle of the energy harvesting button 500. In Fig. 5c, pressure is exerted on the energy harvesting button 500 (indicated by the arrows), for instance, when the foot of the wearer of the shoe gets into contact with the ground. This pressure is transferred onto the piezoelectric plates 510 via the bars 520. As a result of the deformation, an electrical current 555 is generated by each of the bent piezoelectric plates 510. This electrical current also corresponds to a signal of the piezoelectric element. In one example, this signal may be interpreted as a step signal and to increment a step counter. The electric current is then fed 560(Fig. 5d) into the electronic component of the energy harvesting button 500, as is the step signal, which may be forwarded to the corresponding control element (e.g., microcontroller, digital logic or similar component). Thereafter, as described with respect to Fig. 5e, when the pressure is released (e.g., when the shoe is lifted from the ground), another electric current 570 is generated by the piezoelectric elements, as a result of the deformation (transition into the stable state) of the piezoelectric element. Also this further electric current 570 may be transferred 560 to the electronic component and be further processed, as shown in Fig. 5f. Lastly, the obtained step signal (which may have been processed by the microcontroller of the energy harvesting button 500) may be transferred 580 to a remote device 590 (e.g., a smartphone, smartwatch, tablet computer, personal computer or any other suitable device, server, cloud) for display and / or further processing. The invention allows to use the signal of the piezoelectric elements as both, sensor (e.g., as step counter), as well as for operating the electronic components of the energy harvesting button 500, including the transmission to a remote device. With this technique it is also possible to detect the time between two steps, which then could be used to detect the "air time" (e.g. to determine a jump), or to detect step frequency (e.g. steps/minute), or to detect different events during the movement, means to detect based on the time between at least two steps whether the wearer of the shoe is walking, running, jogging, sprinting,..., this can be easily done by comparing the signal with lookup-tables. This event classification as well as the steps, then can be saved in a memory and either transmitted (via Bluetooth Low Energy (BTLE), ZigBee, Near Field Communication (NFC), Bluetooth, Bluetooth Smart, IrDA, WiFi, cellular network standards, or other suitable standards) in real time or after a workout (or movement of the sole). It could be saved in the electronics that after a predefined time the data which is (at least temporally) saved in a memory is transmitted to a remote device. This remote device could be either a smartphone, smartwatch, tablet computer, personal computer or any other suitable device or a server/cloud device.

Fig. 6 is another illustration of an example of an energy harvesting button 600 in accordance with the present invention. The energy harvesting button 600 comprises lower and upper brass covers 610, 620. The brass covers each include a press bar 640 which is for exerting pressure on the piezoelectric elements 650 so that they create electric current as a result of the deformation. The energy harvesting button 600 is protected by the support rings 630. Thus, the piezoelectric elements 650 can be protected from cracking and breaking. The support rings may be manufactured using liquid crystal polymer (LCP) molding. However, other types of manufacture or molding are also conceivable and generally known to the skilled person. Further parts of the energy harvesting button 600 have been omitted in Fig. 6 for clarity reasons. In this way, a self-powered step counter (energy harvesting button 600) can be provided, which has the necessary electronics integrated. The energy harvesting button 600 can be integrated into the insole, but also in the midsole or even the outsole. Depending on the specific construction, a cavity may be needed for the energy harvesting button 600.

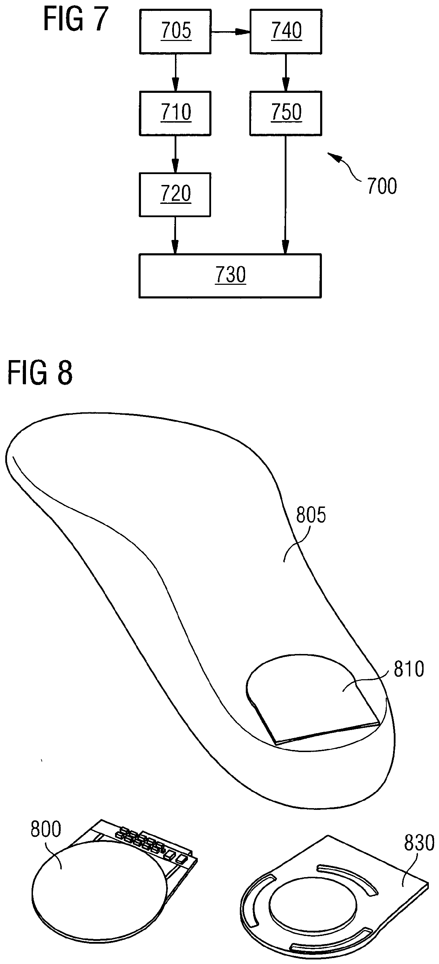

Fig. 7 is a schematic block diagram of an energy harvesting button 700 in accordance with an example of the present invention. It shows the dual functionality of the piezoelectric element, namely to be used for energy harvesting and as sensor element. The piezoelectric element 705 generates an electric current upon bending, as described before. The generated electric current is an alternating current (AC) and can be transferred to the rectifier 710. The rectifier 710 transforms the alternating current into a direct current (DC), which may subsequently be used for the energy management module 720. The energy management module 720 generates a regulated current which can be used for operating the microcontroller 730 and for data analysis. Moreover, the electric current generated by the piezoelectric element 705 may be used for step counting or deriving other motion parameters via the high impedance bridge 740 and the high impedance comparator 750, which generate a voltage pulse to be fed into the microcontroller for subsequent data analysis. The high impedance 740 bridge is a resistance voltage divider. This needs to be of very high resistance to keep the current flow for sensing purposes as low as possible. The high impedance comparator 750 is a component which is comparing voltage levels in two inputs. Normally, one is the reference voltage and the other one is the active voltage (such as a signal from the piezo element). When the active voltage exceeds the reference voltage, the output voltage in comparator goes high. When the active voltage is lower than the reference voltage, the output in the comparator is low.

In this way, the piezoelectric element in the energy harvesting button 700 may be used for two different functions, namely for energy harvesting and step counting. However, also other types of motion parameters can be derived from the electric current such as cadence (time between two signals representing steps), velocity (e.g., when knowing the average step length and the number of steps, which could be either predefined or defined by the user, maybe with help of a mobile device which is connected (via Bluetooth Low Energy (BTLE), ZigBee, Near Field Communication (NFC), Bluetooth, Bluetooth Smart, IrDA, WiFi, cellular network standards or other suitable standards) to the electronics of the energy harvesting button 700) and many others, as described herein. The term mobile device as used herein refers to portable handheld devices which are capable of communicating via one or more of the above mentioned standards. Mobile devices comprise smartphones, smartwatches, tablet PCs, mobile computers, wearable computers, personal digital assistants, game consoles, digital cameras, pagers, smartcards, cell phones, mobile phones, and music players. Mobile devices typically comprise a display, a (virtual) keyboard, a processor, and a memory. However, depending on the type of the mobile device, not all such components may be included. The energy harvesting button 700 of the present invention allows for a low cost solution compared to other solutions (e.g., accelerometer based step detection), it has a low current consumption, and its construction is very simple: For the step counting, the energy harvesting button 700 according to the above shown example requires two resistors and a MOSFET transistor, and for energy harvesting, the energy harvesting button 700 according to the above shown example requires a rectifier bridge (four diodes) and one or more capacitors for energy storage. Moreover, for controlling the components, a microcontroller and a logic IC are needed. The small and lightweight energy harvesting button 700 can easily be integrated into an insole of a shoe (or other parts of a shoe).

Fig. 8 shows an exemplary implementation of an energy harvesting button 800 into an insole which is in agreement with an example of the present invention. As can be seen, insole 805 comprises a cavity 810. The energy harvesting button 800 as described herein may be placed inside the cavity which may be closed using the lid 830. In this way, the energy harvesting button 800 can easily be placed in the insole and used for determining at least one motion parameter and thereby exclusively rely on the energy harvested from the piezoelectric elements. However, it is also conceivable that the energy harvesting button 800 is integrated into the insole (i.e., cannot be removed). In this example, the electronics could be molded against the inside of the insole. The insole can then detect and measure steps by using piezo electric elements (by using the same elements that generate the power), the walking and / or running cadence, the running speed and / or distance. It is also conceivable to use and operate other sensors within the sole of the shoe. For example, other sensors may include an accelerometer, gyroscope, a magnetometer and / or a position sensor (e.g., GPS, Galileo or GLONASS) Of course, also various combinations of these sensors may be used, depending on the typical use of the energy harvesting button. For example, for a sole used when playing basketball, a position sensor may be less necessary than for an energy harvesting button used in a running shoe.

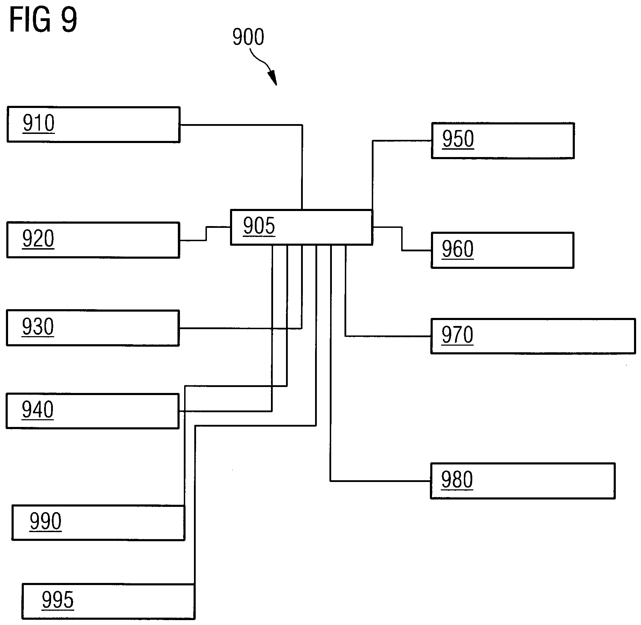

An embodiment of an energy harvesting button 900 of the present invention is shown in Fig. 9. It may comprise a processor 905, a piezoelectric element 910 (as described herein), a memory 950 (e.g. RAM, ROM, flash memory, FRAM memory or similar other suitable memory types), and at least one or more of: energy storage(s) 960 (e.g., the capacitors), a battery 970 (as described above), a transceiver or transmitter unit 980 (e.g. Bluetooth Low Energy (BTLE), ZigBee, Near Field Communication (NFC), Bluetooth, Bluetooth Smart, IrDA, WiFi, cellular network standards or other suitable standards), and additional sensors wherein the at least one sensor is one of a accelerometer 920, gyroscope 930, magnetometer 940, pressure sensor 990 and a position sensor 995 (e.g. GPS, Galileo, GLONASS). Other types of sensors could also be used (not shown). It is to be made clear that an energy harvesting button as described herein does not have to include all of the sensors shown in Fig. 9. Instead, depending on the respective purpose, only one or some of the sensors may be included.

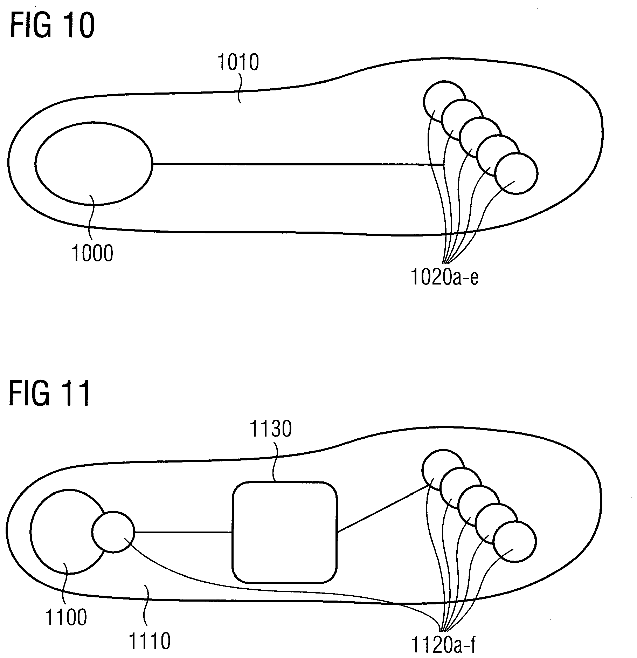

Fig. 10 shows one example use of the herein described energy harvesting button 1000 in an insole. The energy harvesting button 1000 is placed in the heel area of a sole 1010 (e.g., midsole or insole) in combination with several pressure sensors 1020a-e. In this example, there are five pressure sensors which are adapted to measure the pressure exerted in the forefoot area, e.g. by the toes of the wearer. The pressure sensors may be controlled and operated by the energy harvesting button 1000 which includes one or more piezo electric elements for generating energy and suitable control elements for controlling the pressure sensors. It is to be noted that the number, type and placement of sensors and energy harvesting buttons 1000 in Fig. 10 is not representative. Other types of sensors could also be used, different positions in the sole 1010 (midsole or insole) are conceivable and a different number of sensors is also possible, depending on the specific intended use. One example energy harvesting button 1000 which could be used is described within Fig. 9 with the reference number 900.

A further example is shown in Fig. 11. As can be seen, an insole comprises an energy harvesting button 1100 arranged in the heel area of the sole 1110. Similar to the previous figure, five pressure sensors 1120a-e are arranged in the forefoot area to measure the pressure of the forefoot area, e.g. by the toes of the wearer. In addition, there is another pressure sensor 1120f which is arranged in the heel area to measure the pressure exerted by the wearer when contacting the ground with the heel. Additional electronic elements 1130 such as sensors (e.g., position sensor (e.g. GPS, GLONASS, Galileo), temperature sensor, accelerometer, magnetometer, gyroscope or any combination thereof, memory, battery) may be provided in the midfoot area of the insole. Electric elements 1130 may be not removable secured with the insole (or midsole) or removable secured in a cavity (hole or the like) within the insole (or midsole) However, it is to be noted that the number, type and position of the respective sensors may vary. For example, the number of pressure sensors in the forefoot area can be reduced so that only the pressure of the entire forefoot region is measures (as opposed to the pressure by each toe).

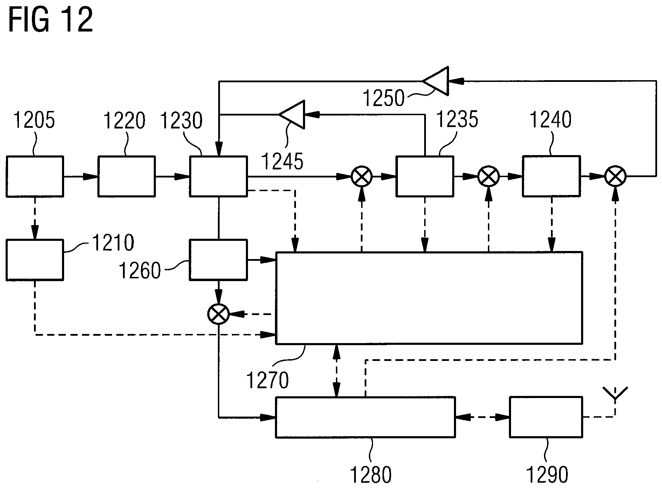

Fig. 12 is another illustration of an example of a energy harvesting button 1200 in accordance with an example of the present invention. As has been described before, one or more piezoelectric elements 1205 create an electric signal or current as a result of a deformation. This electric current may be used for determination 1210 of one or more motion parameters such as step detection. The electric current may then be conveyed to rectifier 1220 which converts the AC signal of the piezoelectric element 1205 into a DC signal.

The first energy storage is loaded first. When the voltage in the first energy storage exceeds a certain level, it will power the voltage regulator 1260 (DCDC converter /LDO regulator). Immediately after that the voltage regulator 1260 will power up power management logic (e.g., power management IC) 1270. Function of the power logic management logic 1270 is that it manages power flow between energy storages (e.g., the capacitors) and know voltage levels that is informed to the microcontroller 1280. The power management logic 1270 checks in one example every 200ms the voltage level in the capacitors 1230 and 1235. Depending on the specific properties, other time intervals for checking the voltage level may also be applicable, such as every 50ms, looms, 300ms or 500ms.

The voltage level detection method can be used with the resistor bridge that is in series with load switch components, which are connected to capacitors. Also direct voltage measurement method can be used.

When the voltage level exceeds a certain limit (for example 4.2V), the power management logic 1270 detects the excess and it will open the power valve between capacitors.

For example, when the voltage limit is exceeded in the first energy storage 1230, the power management logic 1270 will open the power valve between the first energy storage 1230 and second power storage 1235. When power valve is opened, a current will flow to the second energy storage 1235. At the same time the voltage drops in the first power storage 1230, and as soon as it is below a certain threshold (for example 4.2V), the power valve is closed. The same will happen also between the second energy storage 1035 and the third energy storage 1240.

When the voltage level in the second energy storage 1235 rises high enough, the power management logic 1270 detects it and it will give allowance to power up the microcontroller. When the microcontroller is powered up, the voltage levels in the first energy storage 1230 and the second energy storage 1235 starts to drop. When the levels are below a certain threshold, which may be measured by power management logic 1270, a control signal is send to the microcontroller, which initiates a sleep/low power mode. The power control can also be done in other ways, for example the microcontroller may keep itself in on-state for a certain time period, when it exactly knows how much charge is consumed from the energy storages (e.g., capacitors).

When the microcontroller is in on-state, the current flow continues via the voltage regulator 1260 from the first power storage 1030. When voltage level in the first power storage 1230 is lower than that of the second power storage 1035 minus the threshold level of power feedback element 1245 (e.g., a Schottky diode), the current flow also comes from the second energy storage 1235 which supports the first energy storage 1230.

The microcontroller 1280 may also operate the antenna 1290 for subsequent data transmission. In accordance with the examples described herein, the data transmission can be done in two ways: The first one is that a mobile device is carried by the user during the exercise. The data from the energy harvesting button 1200 is sent time to time to the mobile device. For example, the data may be sent in real time or in intervals such as 50ms, 500ms, is, 5s, 10s, 30s, only when the memory is full, or upon request by the user. A second way for data transmission may be realized when the energy harvesting button 1200 is used without the mobile device. Data is collected to a memory which is connected or combined with the energy harvesting button 1200 (e.g. RAM, ROM, flash memory, FRAM memory or similar other suitable memory types). After the exercise, which means after a certain amount of time the energy harvesting button 1200 or the sensors do not produce or receive a signal, the recording stops. The energy harvesting button 1200 connects via a transmitter or transceiver (e.g. Bluetooth Low Energy (BTLE), ZigBee, Near Field Communication (NFC), Bluetooth, Bluetooth Smart, IrDA, WiFi, cellular network standards or other suitable standards) to a router, a server computer, a computer, a mobile device as defined above, or any other suitable medium and transmits the recorded data which was collected during the exercise. One example how it could work in such case may, that the microcontroller detects the transmitter / transceiver signal and opens the valve between the third energy storage 1040 and the power feedback element 1250. By that way it will give enough power for data transmission. The power from the third energy storage 1240 may flow via the power feedback element 1250 to the first energy storage 1230.

In addition, the power from the third energy storage 1240 can be also used for other purposes, like fast start-up of the system. In this way, the energy harvesting button 1200 may manage itself based on self-harvested energy. Nevertheless, the energy harvesting button 1200 is designed to have a very low power consumption. The power storages mentioned above may be one or more of a capacitor, super capacitor, thin film Lithium battery or other suitable types of energy storages (e.g. any battery) which has a lower power leakage and small dimensions. The firmware of the microcontroller and the antenna may be designed in a way that they are in sleep mode when they are not used. This allows for a lower power consumption and a more efficient use of energy.

It is pointed out that the various sensors discussed herein, e.g., with respect to figure 9 may be used in connection with the energy harvesting button 1200 described with respect to Fig. 12. For example, anyone or combinations of accelerometer 920, gyroscope 930, magnetometer 940, pressure sensor 990 and position sensor 995 may be used with the energy harvesting button 1200. In one example, the sensors may be controlled by the control element 1280, which is also adapted for controlling the remainder of the energy harvesting button 1200, and the sensors may obtain the power needed for operating them from the energy storages as described herein.

While the foregoing has been described with respect to piezoelectric elements, it is noted that also other types of elements capable of creating electric current from mechanical strain can be used to realize the invention. Thus, the objective of providing a self-sustaining energy harvesting button comprising one or more sensors wherein the created electric energy is used as both, sensor signal and energy for operating the system may also be realized by such other types of elements (e. g. of an electromagnetic type comprising a body, with permanent magnetization, configured to move within a coil, wherein the movement is created by exerting pressure on the element).

## Claims

1. System for a shoe sole with at least one module, the module comprising:
a. at least one piezo element adapted to produce an electrical signal upon mechanical deformation of the at least one piezo element;
b. wherein the electrical signal is adapted to be used as signal for deriving at least one motion parameter of the shoe sole;
c. at least a first energy storage and a second energy storage, the at least first energy storage and second energy storages being adapted to store electrical energy obtained from the electrical signal;
d. wherein the second energy storage is loaded only after the first energy storage reaches a first energy threshold.

2. System according to claim 1, further comprising a third energy storage being adapted to store electrical energy obtained from the electrical signal.

3. System according to claim 2, wherein the first energy storage is adapted to supply energy for processing the derived at least one motion parameter, wherein the second energy storage is adapted to supply energy for a control element and / or radio frequency functionality, and wherein the third energy storage is adapted to supply energy for transmitting the derived motion parameters.

4. System according to preceding claim, wherein the energy is supplied when the shoe sole is not moving.

5. System according any of the preceding claims, further comprising a control element, wherein the control element is adapted for controlling and / or monitoring the energy levels of the energy storages.

6. System according to any of the preceding claims, further comprising at least one power valve for controlling the energy flow to the at least first and the second energy storages.

7. System according to any of the preceding claims, wherein the energy storages are capacitors, supercapacitors or thin film lithium batteries or combinations thereof.

8. System according to any of the preceding claims, wherein the system is operated by using only energy obtained from the electric signal.

9. System according to any of the preceding claims, further comprising a radio frequency device, wherein the radio frequency device is adapted to transmit data under the Bluetooth Low Energy (BTLE) standard.

10. System according to any of the preceding claims, wherein the at least one motion parameter relates to one or more of: step count, step frequency, pace, cadence, acceleration, speed or distance.

11. System according to any of the preceding claims, wherein the at least one motion parameter is saved in a memory.

12. System according to any of the preceding claims, wherein the electrical signal is further used for determining a duration of use of the shoe.

13. System according to any of the preceding claims, wherein the module is integrated into a cavity of an insole, a midsole or an outsole of a shoe.

14. System according to any of the preceding claims comprising multiple modules, wherein the modules are placed within the sole of the shoe so that they are exposed to maximum forces during treading onto the ground.

15. Shoe sole comprising a system according to any of the preceding claims.

16. Shoe comprising a shoe sole according to the preceding claim.

## Patentansprüche

1. System für eine Schuhsohle aufweisend wenigstens ein Modul, das Modul aufweisend:
a. wenigstens ein Piezoelement eingerichtet zum Erzeugen eines elektrischen Signals bei mechanischer Deformation des wenigstens einen Piezoelements;
b. wobei das elektrische Signal eingerichtet ist, um als Signal zum Ableiten wenigstens eines Bewegungsparameters der Schuhsohle verwendet zu werden;
c. wenigstens ein erster Energiespeicher und ein zweiter Energiespeicher, die wenigstens ersten Energiespeicher und zweiten Energiespeicher sind eingerichtet zum Speichern elektrischer Energie, die von dem elektrischen Signal erhalten wird;
d. wobei der zweite Energiespeicher erst gefüllt wird, nachdem der erste Energiespeicher einen ersten Energieschwellenwert erreicht.

2. System nach Anspruch 1, weiterhin aufweisend einen dritten Energiespeicher, der eingerichtet ist zum Speichern elektrischer Energie, die von dem elektrischen Signal erhalten wird.

3. System nach Anspruch 2, wobei der erste Energiespeicher eingerichtet ist um Energie zum Verarbeiten des wenigstens einen des abgeleiteten wenigstens einen Bewegungsparameters bereitzustellen, wobei der zweite Energiespeicher eingerichtet ist um Energie für ein Steuerelement und/oder Funkfrequenzfunktionalität bereitzustellen, und wobei der dritte Energiespeicher eingerichtet ist um Energie zum Übertragen des abgeleiteten Bewegungsparameters bereitzustellen.

4. System nach dem vorangehenden Anspruch, wobei die Energie bereitgestellt wird, wenn die Schuhsohle nicht in Bewegung ist.

5. System nach einem beliebigen der vorangehenden Ansprüche, weiterhin aufweisend ein Steuerelement, wobei das Steuerelement eingerichtet ist zum Steuern und/oder Überwachen der Energiestufen der Energiespeicher.

6. System nach einem beliebigen der vorangehenden Ansprüche, weiterhin aufweisend wenigstens ein Leistungsventil zum Steuern des Energieflusses zu den wenigstens ersten und zweiten Energiespeichern.

7. System nach einem beliebigen der vorangehenden Ansprüche, wobei die Energiespeicher Kondensatoren, Superkondensatoren oder Dünnfilm-Lithiumbatterien oder Kombinationen hiervon sind.

8. System nach einem beliebigen der vorangehenden Ansprüche, wobei das System betrieben wird nur durch Verwendung von Energie, welche von dem elektrischen Signal erhalten wird.

9. System nach einem beliebigen der vorangehenden Ansprüche, weiterhin aufweisend eine Funkfrequenzvorrichtung, wobei die Funkfrequenzvorrichtung eingerichtet ist um Daten unter dem Bluetooth Low Energy (BTLE) Standard zu übertragen.

10. System nach einem beliebigen der vorangehenden Ansprüche, wobei der wenigstens eine Bewegungsparameter sich auf eines oder mehrere der folgenden bezieht: Schrittzahl, Schrittfrequenz, Tempo, Kadenz, Beschleunigung, Geschwindigkeit oder Distanz.

11. System nach einem beliebigen der vorangehenden Ansprüche, wobei der wenigstens eine Bewegungsparameter in einem Speicher gespeichert wird.

12. System nach einem beliebigen der vorangehenden Ansprüche, wobei das elektrische Signal weiterhin verwendet wird zum Bestimmen einer Benutzungsdauer des Schuhs.

13. System nach einem beliebigen der vorangehenden Ansprüche, wobei das Modul integriert ist in eine Kavität einer Einlegesohle, einer Zwischensohle oder einer Außensohle eines Schuhs.

14. System nach einem beliebigen der vorangehenden Ansprüche aufweisend mehrere Module, wobei die Module innerhalb der Sohle des Schuhs angeordnet sind, sodass sie während des Auftretens auf den Untergrund maximalen Kräften ausgesetzt sind.

15. Schuhsohle aufweisend ein System gemäß einem beliebigen der vorangehenden Ansprüche.

16. Schuh aufweisend eine Schuhsohle gemäß dem vorangehenden Anspruch.

## Revendications

1. Système destiné à une semelle de chaussure avec au moins un module, le module comprenant :
a. au moins un élément piézoélectrique apte à produire un signal électrique sous l'effet d'une déformation mécanique de l'au moins un élément piézoélectrique ;
b. dans lequel le signal électrique est apte à être utilisé en tant que signal pour dériver au moins un paramètre de déplacement de la semelle de chaussure ;
c. au moins un premier stockage d'énergie et un second stockage d'énergie, les au moins un premier stockage d'énergie et second stockage d'énergie étant aptes à stocker une énergie électrique obtenue à partir du signal électrique ;
d. dans lequel le second stockage d'énergie n'est chargé qu'après que le premier stockage d'énergie a atteint un premier seuil d'énergie.

2. Système selon la revendication 1, comprenant en outre un troisième stockage d'énergie qui est apte à stocker de l'énergie électrique obtenue à partir du signal électrique.

3. Système selon la revendication 2, dans lequel le premier stockage d'énergie est apte à délivrer de l'énergie pour le traitement de l'au moins un paramètre de déplacement dérivé, dans lequel le second stockage d'énergie est apte à délivrer de l'énergie pour un élément de contrôle et/ou une fonctionnalité radiofréquence, et dans lequel le troisième stockage d'énergie est apte à délivrer de l'énergie pour l'émission des paramètres de déplacement dérivés.

4. Système selon la revendication précédente, dans lequel l'énergie est délivrée lorsque la semelle de chaussure n'est pas en déplacement.

5. Système selon l'une des revendications précédentes, comprenant en outre un élément de contrôle, l'élément de contrôle étant apte à contrôler et/ou surveiller les niveaux d'énergie des stockages d'énergie.

6. Système selon l'une des revendications précédentes, comprenant au moins une valve d'alimentation pour le contrôle du flux d'énergie vers les au moins un premier et second stockages d'énergie.

7. Système selon l'une des revendications précédentes, dans lequel les stockages d'énergie sont des condensateurs, des super-condensateurs ou des batteries au lithium à film mince, ou des combinaisons des précédents.

8. Système selon l'une des revendications précédentes, dans lequel le système est mis en oeuvre en n'utilisant que l'énergie obtenue à partir du signal électrique.

9. Système selon l'une des revendications précédentes, comprenant en outre un dispositif radiofréquence, le dispositif radiofréquence étant apte à émettre des données suivant le standard Bluetooth basse énergie (BTLE).

10. Système selon l'une des revendications précédentes, dans lequel le au moins un paramètre de déplacement concerne un ou plusieurs d'entre : un comptage de pas, une fréquence des pas, un rythme, une cadence, une accélération, une vitesse ou une distance.

11. Système selon l'une des revendications précédentes, dans lequel le au moins un paramètre de déplacement est sauvegardé dans une mémoire.

12. Système selon l'une des revendications précédentes, dans lequel le signal électrique est en outre utilisé pour déterminer une durée d'utilisation de la chaussure.

13. Système selon l'une des revendications précédentes, dans lequel le module est intégré dans une cavité d'une semelle intérieure, d'une semelle intermédiaire ou d'une semelle extérieure d'une chaussure.

14. Système selon l'une des revendications précédentes comprenant des modules multiples, les modules étant placés à l'intérieur de la semelle de la chaussure de manière à ce qu'ils soient exposés à des forces maximales pendant l'appui sur le sol.

15. Semelle de chaussure comprenant un système selon l'une des revendications précédentes.

16. Chaussure comprenant une semelle de chaussure selon la revendication précédente.
